# EUROPÄISCHE PATENTSCHRIFT

(11) **EP 3 399 425 B1**
(45) Veröffentlichungstag und Bekanntmachung des Hinweises auf die Patenterteilung: **29.07.2020**
(21) Anmeldenummer: 17169690.9
(22) Anmeldetag: 05.05.2017
(51) Int. Cl.: G06F 13/40, H03K 19/003, H03K 19/0175, G01R 31/67

(54) **VERFAHREN ZUR ERKENNUNG EINER VERDRAHTUNGSTOPOLOGIE**
METHOD FOR DETECTING WIRING TOPOLOGY
PROCÉDÉ DESTINÉ À LA DÉTECTION D'UNE TOPOLOGIE DE CÂBLAGE

(43) Veröffentlichungstag der Anmeldung: 07.11.2018
(73) Patentinhaber: dSPACE digital signal processing and control engineering GmbH, 33102 Paderborn (DE)
(72) Erfinder: Lubeley, Dominik, 33415 Verl (DE); Schlenger, Marc, 33104 Paderborn (DE); Kalte, Heiko, 33106 Paderborn (DE)

(56) Entgegenhaltungen:
- WO-A1-03/005212
- US-A1- 2006 215 573
- US-A1- 2016 161 551

## Beschreibung

Die Erfindung betrifft ein Verfahren zur Erkennung einer Verdrahtungstopologie zwischen mindestens zwei FPGAs.

Aus dem Produktkatalog der Firma dSPACE des Jahres 2017, Seite 451 zum DS5203 ist eine Inter-FPGA Kommunikation über einen 32-bit breiten Bus bekannt.

Die WO 03/005212 A1 offenbart ein Inter-Chip Communication System mit einer Verdrahtungstopologie zwischen mindestens zwei FPGAs, wobei ein erster FPGA und ein zweiter FPGA jeweils eine Vielzahl von Interface Pins umfassen, wobei eine Vielzahl von Leitungen zumindest einen Teil der Interface Pins des ersten FPGAs mit zumindest einem Teil der Interface Pins des zweiten FPGAs verbindet.

Aus der US 2006/0215573 A1 ist ein System und eine Methode für die Identifikation von System-Verbindungen bekannt, bei dem in die Register von Treibern eindeutige Erkennungsdaten geladen werden, welche die Treiber über ihre Pins ausgeben. Durch einen Vergleich der von Empfängern empfangenen Daten mit den eindeutigen Erkennungsdaten kann das Identifikationssystem ermitteln, welcher Treiber mit welchem Empfänger verbunden ist.

Nachteilig am Stand der Technik ist, dass eine Prüfung, ob die für die Kommunikation benötigten Leitungen korrekt verdrahtet und intakt sind, sehr aufwendig ist. Eine fehlerhafte Verdrahtung kann Kommunikationsfehler oder auch die Zerstörung der FPGAs bewirken.

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von abhängigen Unteransprüchen.

Gegenstand der Erfindung ist ein Verfahren zur Erkennung einer Verdrahtungstopologie zwischen mindestens zwei FPGAs,
wobei ein erster FPGA eine Vielzahl von Interface Pins, insbesondere einen ersten Interface Pin, umfasst,
wobei ein zweiter FPGA eine Vielzahl von Interface Pins, insbesondere einen zweiten Interface Pin, umfasst,
wobei eine Vielzahl von Leitungen zumindest einen Teil der Interface Pins des ersten FPGAs mit zumindest einem Teil der Interface Pins des zweiten FPGAs verbindet,
wobei ein erster Treiber an dem ersten Interface Pin vorhanden ist,
wobei ein erstes Empfangsregister am zweiten Interface Pin implementiert wird,
wobei am ersten Treiber ein erstes Senderegister implementiert wird,
wobei von dem Senderegister das vom ersten Treiber ausgegebene Signal definiert wird,
wobei der erste Treiber über ein erstes Aktivierungssignal aktiviert wird,
wobei der erste Treiber ein erstes Signal aussendet,
wobei mittels des ersten Empfangsregisters ausgelesen wird, ob das erste Signal am zweiten Interface Pins empfangen wird,
wobei der zweite Interface Pin dem ersten Interface Pin zugeordnet wird, wenn das Signal des ersten Treibers am zweiten Interface Pin empfangen wird.

Es sei angemerkt, dass das Verfahren auch mehrfach für Verbindungen zwischen verschiedenen Pins der beiden FPGAs durchgeführt werden kann. Ebenso kann es zusätzlich zwischen einem oder mehreren Pins des ersten FPGAs und einem oder mehreren Pins eines dritten FPGAs durchgeführt werden. Es kann vorgesehen sein, dass das Signal des ersten Treibers an mehreren Interface-Pins empfangen wird, dann werden alle Interface-Pins an denen das Signal des ersten Treiber empfangen wird dem ersten Interface-Pin zugeordnet.

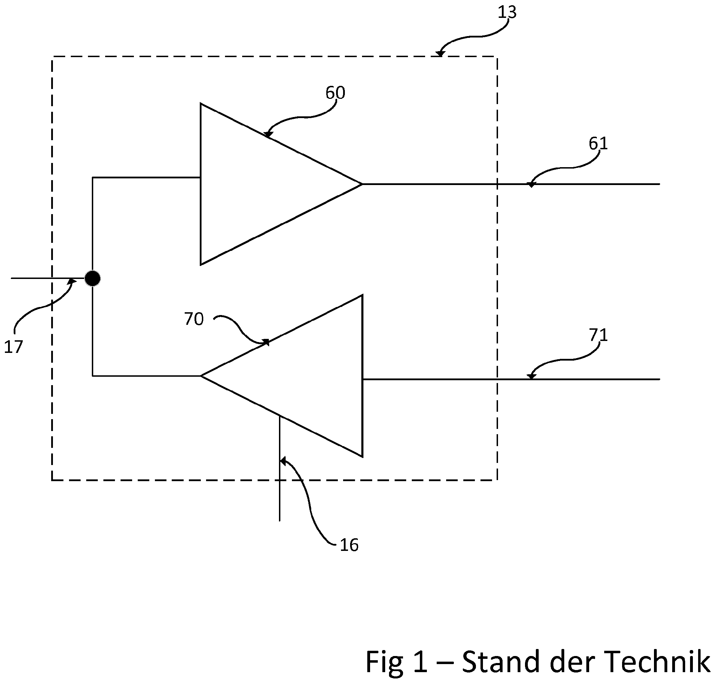

In einem FPGA ist typischerweise für jeden Interface-Pin ein IO-Treiber vorhanden. Ein solcher IO-Treiber ist in Figur 1 gezeigt und wird später genauer beschrieben.

Erfindungsgemäß wird der Ausgang des am zweiten Interface-Pin vorhandenen Lesetreibers mit dem Eingang des ersten Empfangsregisters verbunden. Erfindungsgemäß wird der Ausgang des ersten Senderegisters mit dem Eingangssignal des Schreibtreibers des ersten Treibers verbunden.

Die Zuordnung des zweiten Interface-Pins zu dem ersten Interface-Pin kann abgespeichert oder direkt an den Nutzer ausgegeben werden. Eine Speicherung kann bspw. in Form einer Tabelle, einer Datenbank oder einer anderen Form von Datei oder Informationsstruktur erfolgen. Eine Ausgabe kann als grafische oder textuelle Monitorausgabe oder als Ausdruck erfolgen.

Ein Vorteil des erfindungsgemäßen Verfahrens ist es, dass über die Zuordnung direkt ersichtlich ist, dass zwischen dem ersten Interface-Pin und dem zweiten Interface-Pin eine funktionierende Verbindung besteht. Es ist folglich keine manuelle Prüfung notwendig. Es wird sowohl geprüft ob eine Verbindung zwischen dem ersten Interface-Pin und dem zweiten Interface-Pin besteht, als auch ob die Verbindung korrekt funktioniert. Dadurch können auch mit bloßem Auge nicht sichtbare Schäden der Verbindung erkannt werden.

Das erste Signal kann auch eine Folge von Signalwerten sein. Durch die Überprüfung ob eine bekannte Folge von Signalwerten korrekt über die Verbindung übertragen wird, kann eine zufällige Gleichheit von ausgesendetem und empfangenem Signal vermieden werden.

In einer Ausführungsform wird am ersten Treiber ein erstes Aktivierungsregister implementiert, wobei das erste Aktivierungsregister das erste Aktivierungssignal an den Treiber gibt.

Das Aktivierungssignal wird in dieser Ausführungsform nicht direkt an den Treiber geschickt, sondern in dem Aktivierungsregister zwischengespeichert.

In einer alternativen Ausführungsform wird das Aktvierungssignal durch eine Kontrollinstanz direkt an den Treiber übermittelt.

In einer vorteilhaften Ausführungsform werden die Register über eine Kontrollinstanz angesprochen.

Die Kontrollinstanz kann sowohl auf einem der FPGAs implementiert werden, als auch eine weitere Einheit sein. Die Kontrollinstanz kann bspw. in Form eine Prozessorkerns auf dem ersten und/oder zweiten FPGA implementiert werden. Die Kontrollinstanz kann aber auch ein mit dem ersten und zweiten FPGA verbundener Computer sein. Die Register können von der Kontrollinstanz bspw. über einen Adressbus angesprochen werden. Alternativ können die Register aber auch direkt mit der Kontrollinstanz verbunden werden oder indirekt bspw. über Multiplexer mit der Kontrollinstanz verbunden werden.

In einer weiteren Ausführungsform sind Informationen bekannt, dass der erste Interface Pin mit dem zweiten Interface Pin verbunden sein soll, wobei eine Warnung ausgegeben wird, wenn das erste Signal nicht an dem zweiten Interface Pin empfangen wird.

Ein Vorteil der Ausführungsform ist, dass der Nutzer die Zuordnungen der Interface-Pins nicht manuell prüfen muss. Die Informationen können bspw. aus einem Modellierungstool stammen, in dem die Kommunikation zwischen dem ersten FPGA und dem zweiten FPGA definiert wird. Die Ausgabe der Warnung kann wie die Zuordnung als Speicherung oder als direkte Ausgabe an den Nutzer erfolgen.

Es versteht sich, dass Informationen für eine Vielzahl von Verbindungen zwischen unterschiedlichen Interface-Pins vorhanden sein können. In diesem Fall wird jede Verbindung einzeln geprüft und zumindest für eine fehlerhafte Verbindung, bevorzugt für jede fehlerhafte Verbindung, eine Warnung ausgegeben.

Erfindungsgemäß werden eine Vielzahl von Aktivierungssignalen für jeweils einen Treiber implementiert, wobei die Aktivierungssignale jeweils einzeln einen Treiber aktivieren und alle Interface Pins, an denen das Signal des jeweils aktiven Treibers empfangen wird, dem Interface Pin des aktiven Treibers zugeordnet werden.

Vorteilhaft ist, dass eine Vielzahl von Verbindungen geprüft werden kann, ohne dass ein FPGA zwischen den Prüfungen neu konfiguriert werden muss.

In einer Ausführungsform ist es bevorzugt, dass erste Informationen über ein erstes FPGA-Programm bekannt sind, wobei die ersten Informationen bestimmen, für welche Interface Pins des ersten FPGAs Aktivierungssignale, Senderegister und/oder Empfangsregister implementiert werden.

Auf diese Weise können speziell die Verbindungen an den Interface-Pins geprüft werden, auf denen das erste FPGA-Programm kommunizieren soll. An Interface-Pins, über die das erste FPGA-Programm Informationen aussenden soll, werden Aktivierungssignal und Senderegister implementiert. An Interface-Pins, über die das erste FPGA-Programm Informationen erhalten soll, werden Empfangsregister implementiert.

In einer Weiterbildung wird das erste FPGA-Programm gemeinsam mit dem ersten Senderegister auf dem ersten FPGA implementiert, wobei ein erster Sende-Multiplexer auf dem ersten FPGA implementiert wird, wobei der erste Sende-Multiplexer den ersten Treiber mit dem ersten Senderegister und dem ersten FPGA-Programm verbindet, wobei über den ersten Sende-Multiplexer gesteuert wird, ob das erste Senderegister oder das erste FPGA-Programm das vom ersten Treiber auszugebende Signal definiert.

Der Sende-Multiplexer verbindet also entweder das erste Senderegister mit dem Eingangssignal des Schreibtreibers des ersten Treibers oder das erste FPGA-Programm mit dem Eingangssignal des Schreibtreibers des ersten Treibers. Bevorzugt wird zuerst das erste Senderegister mit dem Treiber verbunden, dann die Verbindung zwischen dem ersten Interface-Pin und dem zweiten Interface-Pin geprüft und dann das erste FPGA-Programm mit dem ersten Interface-Pin verbunden. Auf diese Weise wird die Verbindung geprüft bevor das erste FPGA-Programm eine möglicherweise fehlerhafte Verbindung nutzt. Durch die gemeinsame Implementierung von Senderegister und FPGA-Programm kann das FPGA-Programm nach der Prüfung genutzt werden ohne dass das FPGA nach der Prüfung umkonfiguriert werden muss. Dies spart Zeit und stellt sicher, dass die Verbindungen an genau den Verbindungen geprüft werden, die auch vom ersten FPGA-Programm genutzt werden.

Die Steuerung des Sende-Multiplexers kann von der Kontrollinstanz ausgehen. Das Steuerungssignal kann direkt an den Sende-Multiplexer geleitet werden oder es kann ein Register im FPGA implementiert werden, wobei der Wert des Registers die Schaltung des Sende-Multiplexers definiert und der Wert des Registers von der Kontrollinstanz in das Register geschrieben wird.Gemäß einer anderen Weiterbildung sind zweite Informationen über ein zweites FPGA-Programm bekannt, wobei die zweiten Informationen bestimmen für welche Interface Pins des zweiten FPGAs Aktivierungssignale, Senderegister und/oder Empfangsregister implementiert werden.

Auf diese Weise können speziell die Verbindungen an den Interface-Pins geprüft werden auf denen das zweite FPGA-Programm kommunizieren soll. An Interface-Pins über die das zweite FPGA-Programm Informationen aussenden soll werden Aktivierungssignal und Senderegister implementiert. An Interface-Pins über die das zweite FPGA-Programm Informationen erhalten soll werden Empfangsregister implementiert.

In einer Weiterbildung wird das zweite FPGA-Programm gemeinsam mit einem zweiten Senderegister auf dem zweiten FPGA implementiert, wobei ein zweiter Sende-Multiplexer auf dem zweiten FPGA implementiert wird, wobei der zweite Sende-Multiplexer einen zweiten Treiber mit dem zweiten Senderegister und dem zweiten FPGA-Programm verbindet, wobei über den zweiten Sende-Multiplexer gesteuert wird, ob das zweite Senderegister oder das zweite FPGA-Programm das vom zweiten Treiber auszugebende Signal definiert.

Das zweite Senderegister wird dabei bevorzugt für einen anderen Interface-Pin implementiert als das erste Empfangsregister. Der Interface-Pin wird über eine zweite Leitung mit einem weiteren Interface-Pin an einem FPGA verbunden, an dem wiederrum ein Empfangsregister implementiert sein kann. Auf diese Weise kann eine Verbindung geprüft werden auf der das zweite FPGA-Programm Signale aussenden soll.

Der Schreibtreiber des zweiten Treibers kann über ein Aktivierungssignal aktiviert werden. Bevorzugt werden der erste Treiber und der zweite Treiber nicht gleichzeitig aktiviert. Dadurch wird verhindert, dass die Treiber gegeneinander treiben, falls sie an dieselbe Verbindung angeschlossen sind.

In einer Weiterbildung wird das zweite FPGA-Programm gemeinsam mit dem ersten Empfangsregister auf dem ersten FPGA implementiert, wobei ein erster Empfangs-Multiplexer auf dem zweiten FPGA implementiert wird, wobei der erste Empfangs-Multiplexer das zweite FPGA-Programm mit dem Treiber und einer Konstanten verbindet, wobei über den ersten Empfangs-Multiplexer gesteuert wird, ob das zweite FPGA-Programm die Ausgabe des Treibers oder den Wert der Konstanten empfängt.

Auf diese Weise kann das zweite FPGA-Programm in einem kontrollierten Zustand gehalten werden, unabhängig von den Signalen, die zur Prüfung der Verbindung genutzt werden.

In einer weiteren Ausführungsform wird an einem dritten Interface Pin ein zweites Empfangsregister implementiert, wobei mittels des zweiten Empfangsregisters ausgelesen wird, ob das erste Signal am dritten Interface Pin empfangen wird, wobei der dritte Interface Pin dem ersten Interface Pin zugeordnet wird, wenn das erste Signal an dem dritten Interface Pin empfangen wird.

Es wird so möglich, dass dem ersten Interface-Pin sowohl der zweite Interface-Pin, als auch der dritte Interface-Pin zugeordnet werden. Es können also Punkt-zu-Multipunkt-Verbindungen geprüft werden. Auch diese Zuordnungen können wieder mit Informationen über FPGA-Programme verglichen werden und so kann festgestellt werden, ob die gewünschten Verbindungen funktionsfähig sind.

In einer weiteren Ausführungsform wird an dem zweiten Interface Pin ein zweites Aktivierungssignal implementiert, wobei eine Warnung ausgegeben wird, falls das erste Signal am zweiten Interface Pin empfangen wird.

An einer Leitung darf immer nur ein Sendetreiber aktiv sein, ansonsten besteht die Gefahr eines Kurzschlusses, wenn mehrere Treiber gegeneinander treiben. Sollten dennoch mehrere Aktivierungssignale an Interface-Pins implementiert werden, die über eine Verbindung miteinander verbunden sind, so wird eine Warnung ausgegeben. Dadurch wird dem Nutzer die Möglichkeit gegeben die Verbindung zu ändern oder die Aktivierungssignale an anderen Interface-Pins zu implementieren. Wird das erste Aktivierungssignal am ersten Interface-Pin basierend auf Informationen über das erste FPGA-Programm implementiert und das zweite Aktivierungssignal am zweiten Interface-Pin basierend auf Informationen über das zweite FPGA-Programm implementiert, so sind die beiden Programm wahrscheinlich inkompatibel miteinander oder die Verbindung fehlerhaft. Die Warnung gibt dem Nutzer die Möglichkeit auf die Inkompatibilität oder die fehlerhafte Verbindung zu reagieren.

In einer anderen Ausführungsform werden an allen Interface Pins jeweils ein Aktivierungssignal, ein Senderegister und ein Empfangsregister implementiert.

Durch die an allen Interface-Pins vorhandenen Aktivierungssignale und Register können alle Verbindungen zwischen allen Interface-Pins geprüft werden.

In einer Fortbildung wird eine vollständige Verdrahtungstopologie bestimmt.

Indem jeder Sendetreiber einzeln über das jeweilige Aktivierungssignal aktiviert wird und alle Interface-Pins, an denen das ausgesendete Signal empfangen wird, dem Interface-Pin des jeweils aktiven Sendetreibers zugeordnet werden, wird die Verdrahtungstopologie bestimmt. Die Verdrahtungstopologie kann dann genutzt werden, um die von den FPGA-Programmen, die auf den jeweiligen FPGAs laufen sollen, zur Kommunikation genutzten Interface-Pins zu bestimmen.

In einer Ausführungsform wird für jedes Aktvierungssignal ein Aktivierungsregister implementiert.

Das Aktivierungsregister enthält dann das Aktivierungssignal. Durch ein einfaches Beschreiben des Registers kann so das Aktivierungssignal aktiviert bzw. deaktiviert werden.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbare geometrische Relation zueinander auf. Darin zeigt:
- Figur 1: eine schematische Ansicht auf einen IO-Treiber eines FPGA,
- Figur 2: eine schematische Ansicht auf zwei FPGAs, die über eine Vielzahl von Leitungen miteinander verbunden sind,
- Figur 3: eine schematische Ansicht auf einen IO-Treiber mit einem Empfangsregister
- Figur 4: eine schematische Ansicht auf einen IO-Treiber mit einem Senderegister
- Figur 5: eine schematische Darstellung der Verfahrensschritte eines erfindungsgemäßen Verfahrens,
- Figur 6: eine schematische Ansicht auf einen IO-Treiber mit einem Senderegister und einem Aktivierungsregister,
- Figur 7: eine schematische Ansicht auf einen IO-Treiber mit einem Empfangsregister, einem Senderegister, einem Aktivierungsregister und einem FPGA-Programm,
- Figur 8: eine schematische Ansicht auf drei FPGAs, die über eine Vielzahl von Leitungen miteinander verbunden sind.

Figur 1 zeigt einen in einem FPGA vorhandenen bekannten IO-Treiber. Ein IO-Treiber 13 besteht aus einem Lesetreiber 60 und einem Schreibtreiber 70. Der Lesetreiber 60 ist immer aktiv. Der Lesetreiber 60 wertet das am Interface-Pin anliegende Signal 17 aus und stellt den logischen Wert 61 den Funktionen im FPGA zur Verfügung. Der Schreibtreiber 70 kann über ein Aktivierungssignal 16 aktiviert werden. Ist der Schreibtreiber 70 aktiv, so wandelt er ein anliegendes logisches Signal 71 in eine feste Spannung, die er über den Interface-Pin ausgibt. Über ein Eingangssignal des Schreibtreibers wird definiert welches Signal 17 der Schreibtreiber über den Interface-Pin ausgibt.

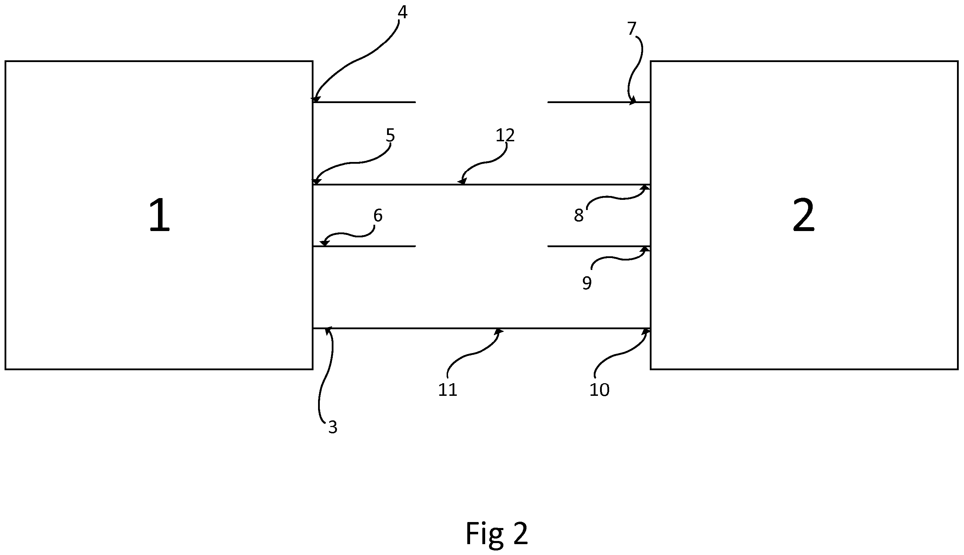

Figur 2 zeigt einen ersten FPGA 1 mit einem ersten Interface-Pin 5 und einen zweiten FPGA 2 mit einem zweiten Interface-Pin 8. Eine Vielzahl von Leitungen 11, 12 verbindet einen Teil der Interface-Pins 3, 4, 5, 6 des ersten FPGAs 1 mit einem Teil der Interface-Pins 7, 8, 9, 10 des zweiten FPGAs 2. Dabei verbindet eine erste Leitung 12 den ersten Interface-Pin 5 mit dem zweiten Interface-Pin 8.

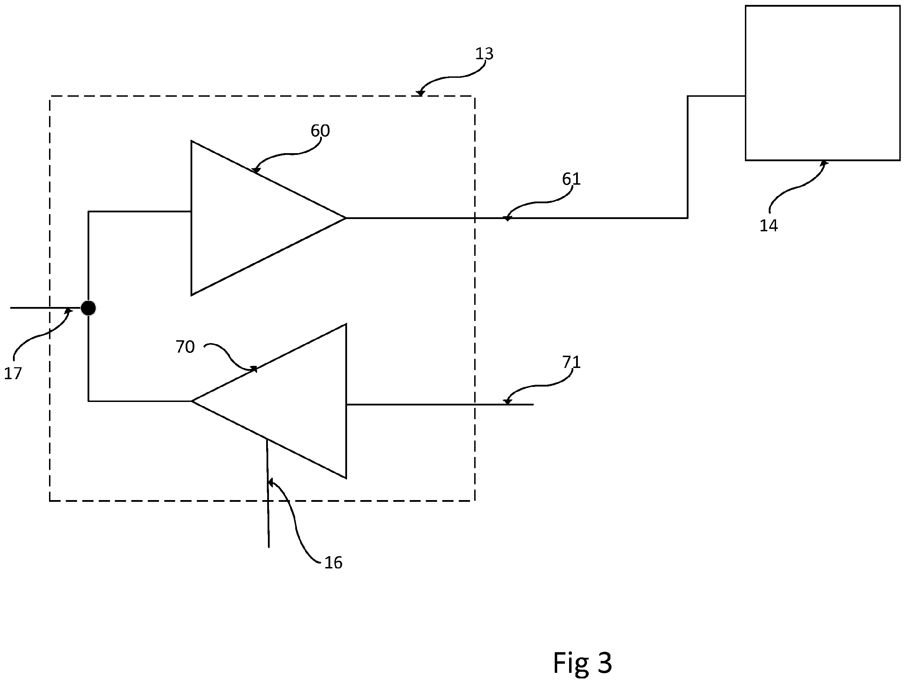

Figur 3 zeigt einen am zweiten Interface-Pin 8 implementierten Treiber 13. Ein Empfangsregister 14 wird in dem zweiten FPGA 2 implementiert und mit dem Lesetreiber 60 verbunden. Das an dem zweiten Interface-Pin 8 anliegende Signal 17 wird von dem Lesetreiber 60 ausgewertet und als logischer Wert 61 in das Empfangsregister 14 geschrieben. Es versteht sich, dass Empfangsregister 14 an jedem IO-Treiber 13 und damit an jedem Interface-Pin 3, 4, 5, 6, 7, 8, 9, 10, 50, 51, 52 implementiert werden können.

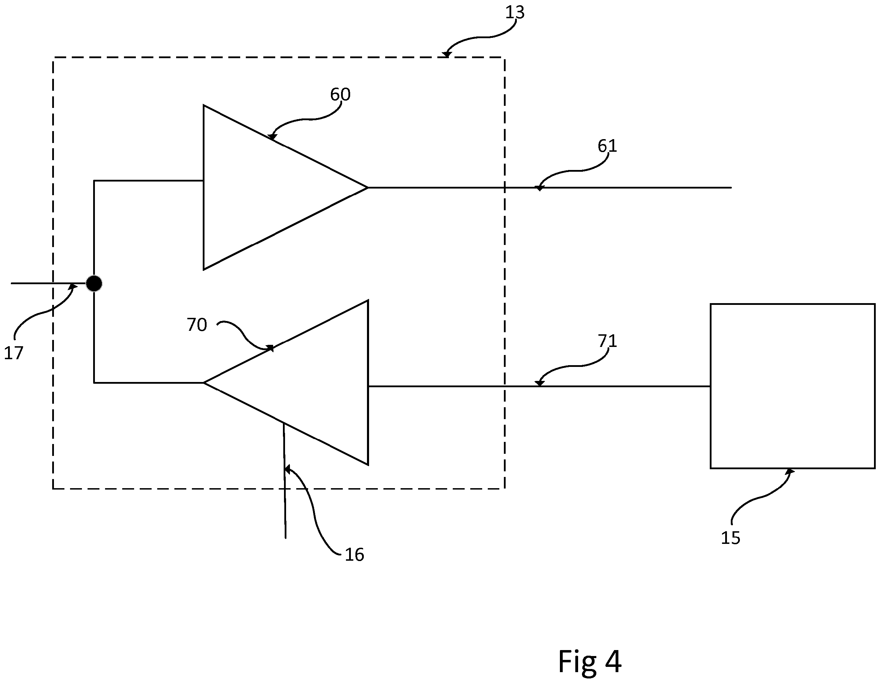

Figur 4 zeigt einen am ersten Interface-Pin 5 implementierten Treiber 13. Ein Senderegister 15 wird mit dem Schreibtreiber 70 verbunden. Wenn das Aktivierungssignal 16 den Schreibtreiber 70 aktiviert, so setzt der Schreibtreiber 16 den logischen Wert 71 des Senderegisters 15 in ein über den ersten Interface-Pin 5 auszugebendes Signal 17 um. Es versteht sich, dass Senderegister 15 an jedem IO-Treiber 13 implementiert werden können.

Das Empfangsregister 14 und das Senderegister 15 können über verschiedene bekannte Techniken beschrieben bzw. ausgelesen werden. Die dazu nötigen Leitungen und Logikschaltungen sind hier nicht gezeigt.

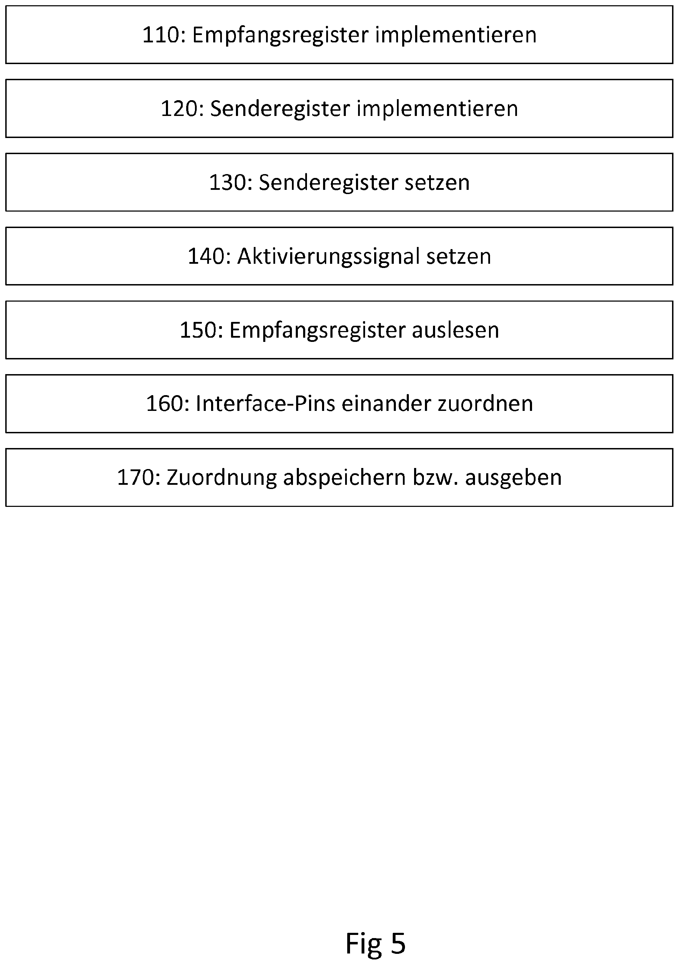

Figur 5 zeigt ein Verfahren, wie es mit den in Figur 2 gezeigten FPGAs ausgeführt werden kann. Dabei wird in einem ersten Schritt 110 auf dem zweiten FPGA 2 das in Figur 3 gezeigt Empfangsregister 14 am zweiten Interface-Pin 8 implementiert In einem zweiten Schritt 120 wird auf dem ersten FPGA 1 das in Figur 4 gezeigte Senderegister 15 am ersten Interface-Pin 5 implementiert. In einem dritten Schritt 130 wird das Senderegister 15 gesetzt. In einem vierten Schritt 140 wird das Aktivierungssignal 16 gesetzt und damit der Schreibtreiber 70 am ersten Interface-Pin 5 aktiviert. In einem fünften Schritt 150 wird das Empfangsregister 14 ausgelesen. Wenn der im dritten Schritt 130 in das Senderegister 15 gesetzte Wert 71 im fünften Schritt 150 aus dem Empfangsregister 14 ausgelesen wurde, so werden die Interface-Pins 5, 8 in einem sechsten Schritt 160 einander zugeordnet. Die Zuordnung wird dann in einem siebten Schritt 170 abgespeichert oder an den Nutzer ausgegeben. Wenn der im dritten Schritt 130 in das Senderegister 15 gesetzte Wert 71 im fünften Schritt 150 nicht aus dem Empfangsregister 14 ausgelesen wurde, so bricht das Verfahren ab oder gibt eine Meldung aus, dass keine Zuordnung durchgeführt werden konnte.

Werden eine Vielzahl an Empfangsregistern 14 und/oder Senderegistern 15 an jeweils einem Treiber 13 implementiert, so können eine Vielzahl von Leitungen 11, 12 geprüft werden. In diesem Fall werden die Schritte vier bis sieben wiederholt ausgeführt. Das Aktivierungssignal 16 wird im vierten Schritt 140 jeweils nur für einen einzelnen Schreibtreiber 70 gesetzt. Im fünften Schritt 150 werden alle Empfangsregister 14 ausgelesen. Alle Interface-Pins 3, 4, 5, 6, 7, 8, 9, 10, 50, 51, 52, aus deren Empfangsregister 14 der im dritten Schritt 130 gesetzte Wert 71 im fünften Schritt 150 ausgelesen wurde, werden im sechsten Schritt 160 dem Interface-Pin 3, 4, 5, 6, 7, 8, 9, 10, 50, 51, 52 mit dem jeweils aktiven Treiber 13 zugeordnet. Die Zuordnung wird dann in einem siebten Schritt 170 abgespeichert oder an den Nutzer ausgegeben. Die Schritte vier bis sieben werden wiederholt, bis alle Schreibtreiber 70 jeweils einmal aktiv waren.

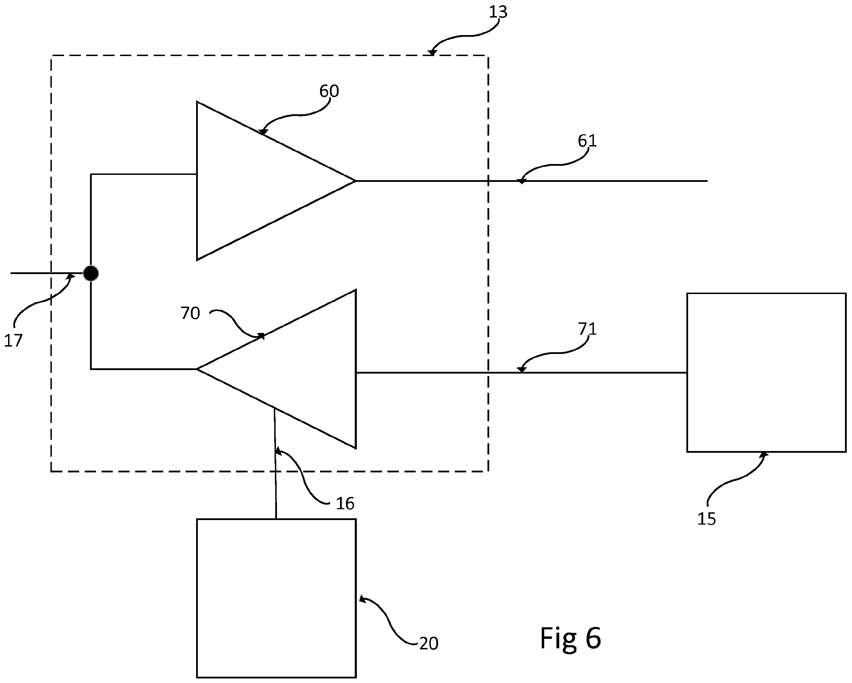

Figur 6 zeigt einen alternativen am ersten Interface-Pin 5 implementierten Treiber 13. Im Unterschied zu Figur 4 wird ein Aktivierungsregister 20 im ersten FPGA 1 implementiert. Das Aktivierungsregister 20 enthält das Aktivierungssignal 16 für den Schreibtreiber 70. Der Schreibtreiber 70 kann in dieser Ausführungsform über das Setzen des Aktivierungsregisters 20 aktiviert werden.

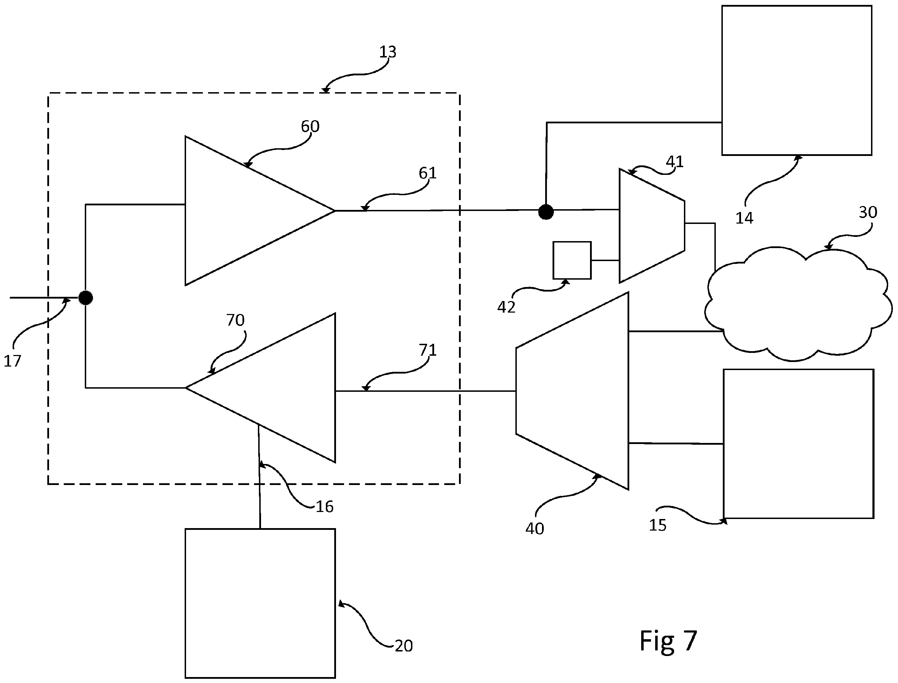

Figur 7 zeigt die Implementierung von Empfangsregister 14 und Senderegister 15 gemeinsam mit einem FPGA-Programm 30 an einem IO-Treiber 13. Es wird auf dem FPGA 1, 2, 80 ein Sende-Multiplexer 40 implementiert. Der Sende-Multiplexer 40 verbindet entweder das Senderegister 15 mit dem Schreibtreiber 70 oder das FPGA-Programm 30 mit dem Schreibtreiber 70. Zum Prüfen der Verbindungen wird zunächst das Senderegister 15 über den Sende-Multiplexer 40 mit dem Schreibtreiber verbunden. Nach Abschluss der Prüfung für alle mit einem Senderegister verbundenen Treiber werden die Sende-Multiplexer 40 umgeschaltet und das FPGA-Programm 30 mit den Schreibtreibern verbunden. Zusätzlich wird ein Empfangs-Multiplexer 41 und eine Konstante 42 auf dem FPGA implementiert. Der Empfangsmultiplexer verbindet entweder die Konstante 42 mit dem FPGA Programm oder leitet das vom Lesetreiber 60 bereitgestellte Signal 61 dem FPGA-Programm zu. Das Empfangsregister ist fest mit dem Treiber verbunden und erhält das vom Lesetreiber bereitgestellte Signal. Zum Prüfen der Verbindung wird das FPGA-Programm 30 mit der Konstanten 42 verbunden. Nach Abschluss der Prüfung wird der Empfangs-Multiplexer 41 umgeschaltet und der Lesetreiber 60 mit dem FPGA-Programm 30 verbunden. Wenn der Empfangs-Multiplexer 41 das FPGA-Programm 30 mit dem Treiber 13 verbindet ist es möglich den vom Lesetreiber 60 bereitgestellten Wert 61 sowohl im FPGA-Programm 30 zu nutzen als auch über das Empfangsregister 14 auszulesen. Es versteht sich, dass Empfangsregister und Empfangs-Multiplexer an einer Vielzahl von Interface-Pins zusammen mit einem FPGA-Programm auf einem FPGA implementiert werden können.

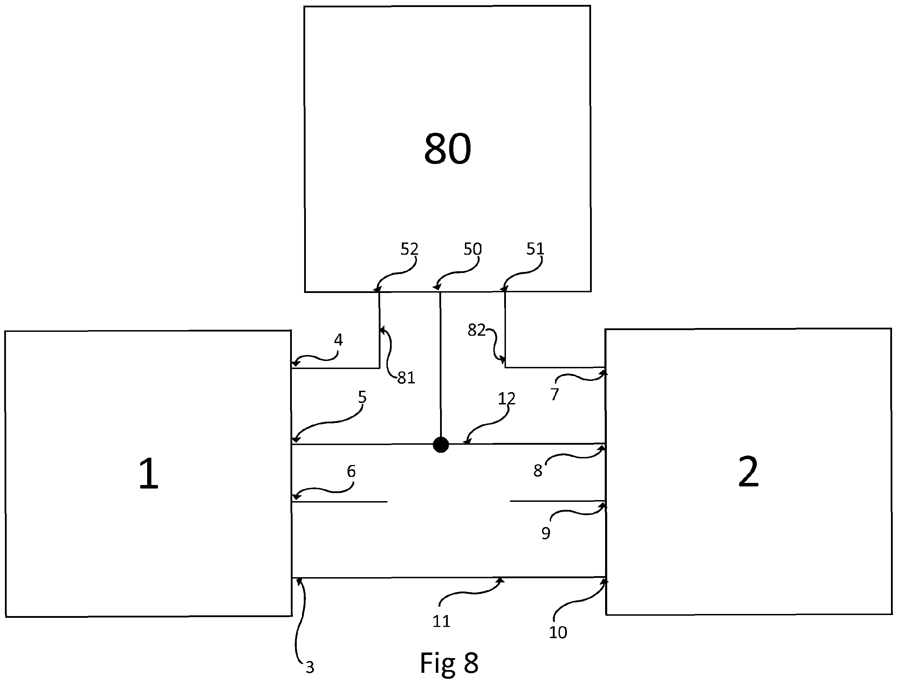

Figur 8 zeigt eine schematische Ansicht auf drei FPGAs, die über eine Vielzahl von Leitungen 11, 12, 81, 82 miteinander verbunden sind. Eine zweite Leitung 81 verbindet einen Interface-Pin 4 des ersten FPGAs 1 mit einem Interface-Pin 52 des dritten FPGAs 80 und eine dritte Leitung 82 verbindet einen Interface-Pin 7 des zweiten FPGAs 2 mit einem Interface-Pin 51 des dritten FPGAs 80. Eine vierte Leitung 11 verbindet einen Interface-Pin 3 des ersten FPGA 1 mit einem Interface-Pin 10 des zweiten FPGA 2. Die erste Leitung 12 verbindet in diesem Beispiel den ersten Interface-Pin 5 des ersten FPGA 1 mit dem zweiten Interface-Pin 8 des zweiten FPGA 2 und einem dritten Interface-Pin 50 des dritten FPGA 80. Es versteht sich, dass diese Verbindungen nur bespielhaft sind. Prinzipiell kann jeder Interface-Pin mit jedem anderen Interface-Pin verbunden werden. Wenn an allen Interface-Pins Sende- und Empfangsregister 14, 15 implementiert werden, können alle Leitungen 11, 12, 81, 82 geprüft und eine vollständige Verdrahtungstopologie erstellt werden. Werden nur an einem Teil der Interface-Pins Sende- und/oder Empfangsregister 14, 15 implementiert, so kann nur eine teilweise Verdrahtungstopologie erstellt werden.

## Patentansprüche

1. Verfahren zur Erkennung einer Verdrahtungstopologie zwischen mindestens zwei FPGAs (1, 2),
wobei ein erster FPGA (1) eine Vielzahl von Interface Pins (3, 4, 5, 6), insbesondere einen ersten Interface Pin (5), umfasst,
wobei ein zweiter FPGA (2) eine Vielzahl von Interface Pins (7, 8, 9, 10), insbesondere einen zweiten Interface Pin (8), umfasst,
wobei eine Vielzahl von Leitungen (11, 12) zumindest einen Teil der Interface Pins (3, 4, 5, 6) des ersten FPGAs (1) mit zumindest einem Teil der Interface Pins (7, 8, 9, 10) des zweiten FPGAs (2) verbindet,
wobei ein erster Treiber (13) an dem ersten Interface Pin (5) vorhanden ist,
wobei am ersten Treiber (13) ein erstes Senderegister (15) implementiert wird,
wobei von dem Senderegister (15) das vom ersten Treiber (13) ausgegebene Signal (17) definiert wird,
**dadurch gekennzeichnet, dass**
ein erstes Empfangsregister (14) am zweiten Interface Pin (8) implementiert wird,
wobei der erste Treiber (13) über ein erstes Aktivierungssignal (16) aktiviert wird,
wobei der erste Treiber (13) ein erstes Signal (17) aussendet,
wobei mittels des ersten Empfangsregisters (14) ausgelesen wird, ob das erste Signal (17) am zweiten Interface Pins (10) empfangen wird,
wobei der zweite Interface Pin (8) dem ersten Interface Pin (5) zugeordnet wird, wenn das erste Signal (17) des ersten Treibers (13) am zweiten Interface Pin (8) empfangen wird, wobei eine Vielzahl von Aktivierungssignalen (16) für jeweils einen Treiber (13) implementiert werden, wobei die Aktivierungssignale (16) jeweils einzeln einen Treiber (13) aktivieren und alle Interface Pins (3, 4, 5, 6, 7, 8, 9, 10), an denen das Signal des jeweils aktiven Treibers (13) empfangen wird, dem Interface Pin (3, 4, 5, 6, 7, 8, 9, 10) des aktiven Treibers (13) zugeordnet werden.

2. Verfahren nach Anspruch 1, **dadurch gekennzeichnet, dass** am ersten Treiber (13) ein erstes Aktivierungsregister (20) implementiert wird, wobei das erste Aktivierungsregister (20) das erste Aktivierungssignal (16) an den ersten Treiber (13) gibt.

3. Verfahren nach Anspruch 1, **dadurch gekennzeichnet, dass** das Aktvierungssignal (16) durch eine Kontrollinstanz direkt an den Treiber (13) übermittelt wird.

4. Verfahren nach einem der vorhergehenden Ansprüche, **dadurch gekennzeichnet, dass** die Register (14, 15, 20) über eine Kontrollinstanz angesprochen werden.

5. Verfahren nach einem der vorhergehenden Ansprüche, **dadurch gekennzeichnet, dass** Informationen bekannt sind, dass der erste Interface Pin (5) mit dem zweiten Interface Pin (8) verbunden sein soll, wobei eine Warnung ausgegeben wird, wenn das erste Signal (17) nicht an dem zweiten Interface Pin (8) empfangen wird.

6. Verfahren nach einem der vorhergehenden Ansprüche, **dadurch gekennzeichnet, dass** erste Informationen über ein erstes FPGA-Programm (30) bekannt sind, wobei die ersten Informationen bestimmen für welche Interface Pins (3, 4, 5, 6) des ersten FPGAs (1) Aktivierungssignale (16), Senderegister (15) und/oder Empfangsregister (14) implementiert werden.

7. Verfahren nach Anspruch 6, **dadurch gekennzeichnet, dass** das erste FPGA-Programm (30) gemeinsam mit dem ersten Senderegister (15) auf dem ersten FPGA (1) implementiert wird, wobei ein erster Sende-Multiplexer (40) auf dem ersten FPGA (1) implementiert wird, wobei der erste Sende-Multiplexer (40) den ersten Treiber (13) mit dem ersten Senderegister (15) und dem ersten FPGA-Programm (30) verbindet, wobei über den ersten Sende-Multiplexer (40) gesteuert wird, ob das erste Senderegister (15) oder das erste FPGA-Programm (30) das vom ersten Treiber (13) auszugebende Signal (17) definiert.

8. Verfahren nach einem der vorhergehenden Ansprüche, **dadurch gekennzeichnet, dass** zweite Informationen über ein zweites FPGA-Programm (30) bekannt sind, wobei die zweiten Informationen bestimmen für welche Interface Pins (7, 8, 9, 10) des zweiten FPGAs (2) Aktivierungssignale (16), Senderegister (15) und/oder Empfangsregister (14) implementiert werden.

9. Verfahren nach Anspruch 8, **dadurch gekennzeichnet, dass** das zweite FPGA-Programm (30) gemeinsam mit einem zweiten Senderegister (15) auf dem zweiten FPGA (2) implementiert wird, wobei ein zweiter Sende-Multiplexer (40) auf dem zweiten FPGA (2) implementiert wird, wobei der zweite Sende-Multiplexer (40) einen zweiten Treiber (13) mit dem zweiten Senderegister (15) und dem zweiten FPGA-Programm (30) verbindet, wobei über den zweiten Sende-Multiplexer (40) gesteuert wird, ob das zweite Senderegister (15) oder das zweite FPGA-Programm (30) das vom zweiten Treiber (13) auszugebende Signal (17) definiert.

10. Verfahren nach einem der vorhergehenden Ansprüche, **dadurch gekennzeichnet, dass** an einem dritten Interface Pin (50) ein zweites Empfangsregister (14) implementiert wird, wobei mittels des zweiten Empfangsregisters (14) ausgelesen wird, ob das erste Signal (17) am dritten Interface Pin (50) empfangen wird, wobei der dritte Interface Pin (50) dem ersten Interface Pin (5) zugeordnet wird, wenn das erste Signal (17) an dem dritten Interface Pin (50) empfangen wird.

11. Verfahren nach einem der vorhergehenden Ansprüche, **dadurch gekennzeichnet, dass** an dem zweiten Interface Pin (8) ein zweites Aktivierungssignal (16) implementiert wird, wobei eine Warnung ausgegeben wird, falls das erste Signal (17) am zweiten Interface Pin (8) empfangen wird.

12. Verfahren nach einem der Ansprüche 1 bis 5, **dadurch gekennzeichnet, dass** an allen Interface Pins (3, 4, 5, 6, 7, 8, 9, 10, 50, 51, 52) jeweils ein Aktivierungssignal (16), ein Senderegister (15) und ein Empfangsregister (14) implementiert werden.

13. Verfahren nach Anspruch 12, **dadurch gekennzeichnet, dass** eine vollständige Verdrahtungstopologie bestimmt wird.

14. Verfahren nach einem der vorhergehenden Ansprüche, **dadurch gekennzeichnet, dass** für jedes Aktivierungssignal (16) ein Aktivierungsregister (20) implementiert wird.

## Claims

1. A method for recognizing a wiring topology between at least two FPGAs (1, 2),
a first FPGA (1) comprising a plurality of interface pins (3, 4, 5, 6), particularly a first interface pin (5), a second FPGA (2) comprising a plurality of interface pins (7, 8, 9, 10), particularly a second interface pin (8), a plurality of lines (11, 12) connecting at least a part of the interface pins (3, 4, 5, 6) of the first FPGA (1) to the at least a part of the interface pins (7, 8, 9, 10) of the second FPGA (2), a first driver (13) being present on the first interface pin (5),
a first transmitter register (15) being implemented on the first driver (13),
the signal (17) output by the first driver (13) being defined by the transmitter register (15),
**characterized in that**
a first receiver register (14) is implemented on the second interface pin (8),
wherein the first driver (13) is activated via a first activation signal (16),
wherein the first driver (13) sends out a first signal (17), wherein the first receiver register (14) is used to read whether the first signal (17) is received at the second interface pin (10), wherein the second interface pin (8) is associated with the first interface pin (5) when the first signal (17) of the first driver (13) is received at the second interface pin (8), wherein a plurality of activation signals (16) are implemented for each driver (13), wherein the activation signals (16) each individually activate a driver (13) and all interface pins (3, 4, 5, 6, 7, 8, 9, 10) at which the signal of the respectively active driver (13) is received are associated with the interface pin (3, 4, 5, 6, 7, 8, 9, 10) of the active driver (13) .

2. The method according to claim 1,
**characterized in that** a first activation register (20) is implemented on the first driver (13), wherein the first activation register (20) gives the first activation signal (16) to the first driver (13).

3. The method according to claim 1,
**characterized in that** the activation signal (16) is transmitted directly to the driver (13) by a control instance.

4. The method according to any one of the preceding claims, **characterized in that** the registers (14, 15, 20) are addressed via a control instance.

5. The method according to any one of the preceding claims, **characterized in that** information, that the first interface pin (5) is to be connected to the second interface pin (8), is known, wherein a warning is output when the first signal (17) is not received at the second interface pin (8).

6. The method according to any one of the preceding claims, **characterized in that** first information about a first FPGA program (30) is known, wherein the first information determines for which interface pins (3, 4, 5, 6) of the first FPGA (1) activation signals (16), transmitter registers (15) and/or receiver registers (14) can be implemented.

7. The method according to claim 6,
**characterized in that** the first FPGA program (30) is implemented together with the first transmitter register (15) on the first FPGA (1), wherein a first transmit multiplexer (40) is implemented on the first FPGA (1), wherein the first transmit multiplexer (40) connects the first driver (13) to the first transmitter register (15) and the first FPGA program (30), wherein the first transmit multiplexer (40) is used to control whether the first transmitter register (15) or the first FPGA program (30) defines the signal (17) to be output by the first driver (13).

8. The method according to any one of the preceding claims, **characterized in that** second information about a second FPGA program (30) is known, wherein the second information determines for which interface pins (7, 8, 9, 10) of the second FPGA (2) activation signals (16), transmitter registers (15) and/or receiver registers (14) can be implemented.

9. The method according to claim 8,
**characterized in that** the second FPGA program (30) is implemented together with a second transmitter register (15) on the second FPGA (2), wherein a second transmit multiplexer (40) is implemented on the second FPGA (2), wherein the second transmit multiplexer (40) connects a second driver (13) to the second transmitter register (15) and the second FPGA program (30), wherein the second transmit multiplexer (40) is used to control whether the second transmitter register (15) or the second FPGA program (30) defines the signal (17) to be output by the second driver (13) .

10. The method according to any one of the preceding claims, **characterized in that** a second receiver register (14) is implemented on a third interface pin (50), wherein the second receiver register (14) is used to read whether the first signal (17) is received on the third interface pin (50), wherein the third interface pin (50) is associated with the first interface pin (5) when the first signal (17) is received at the third interface pin (50).

11. The method according to any one of the preceding claims, **characterized in that** a second activation signal (16) is implemented on the second interface pin (8), wherein a warning is output if the first signal (17) is received at the second interface pin (8).

12. The method according to any one of claims 1 to 5, **characterized in that** an activation signal (16), a transmitter register (15) and a receiver register (14) are implemented on all interface pins (3, 4, 5, 6, 7, 8, 9, 10, 50, 51, 52).

13. The method according to claim 12,
**characterized in that** that a complete wiring topology is determined.

14. The method according to any one of the preceding claims, **characterized in that** an activation register (20) is implemented for each activation signal (16).

## Revendications

1. Procédé pour identifier une topologie de câblage entre au moins deux FPGA (1, 2),
dans lequel un premier FPGA (1) comprend une pluralité de broches d'interface (3, 4, 5, 6), en particulier une première broche d'interface (5),
dans lequel un second FPGA (2) comprend une pluralité de broches d'interface (7, 8, 9, 10), en particulier une seconde broche d'interface (8),
dans lequel une pluralité de lignes (11, 12) connectent au moins une partie des broches d'interface (3, 4, 5, 6) du premier FPGA (1) à au moins une partie des broches d'interface (7, 8, 9, 10) du second FPGA (2),
dans lequel un premier pilote (13) existe sur la première broche d'interface (5),
dans lequel un premier registre d'émission (15) est mis en œuvre sur le premier pilote (13),
dans lequel le signal (17) émis par le premier pilote (13) est défini par le registre d'émission (15),
**caractérisé en ce qu'**
un premier registre de réception (14) est mis en œuvre à la seconde broche d'interface (8),
dans lequel le premier pilote (13) est activé via un premier signal d'activation (16),
dans lequel le premier pilote (13) émet un premier signal (17),
dans lequel il est lu au moyen du premier registre de réception (14) si le premier signal (17) est reçu à la seconde broche d'interface (10),
dans lequel la seconde broche d'interface (8) est affectée à la première broche d'interface (5) si le premier signal (17) du premier pilote (13) est reçu à la seconde broche d'interface (8), dans lequel une pluralité de signaux d'activation (16) sont mis en œuvre pour un pilote (13) respectivement, dans lequel les signaux d'activation (16) activent chacun individuellement un pilote (13) et toutes les broches d'interface (3, 4, 5, 6, 7, 8, 9, 10) auxquelles est reçu le signal du pilote (13) respectivement actif sont affectées à la broche d'interface (3, 4, 5, 6, 7, 8, 9, 10) du pilote (13) actif.

2. Procédé selon la revendication 1, **caractérisé en ce qu'**un premier registre d'activation (20) est mis en œuvre au premier pilote (13), dans lequel le premier registre d'activation (20) transmet le premier signal d'activation (16) au premier pilote (13).

3. Procédé selon la revendication 1, **caractérisé en ce que** le signal d'activation (16) est transmis via une instance de contrôle directement au pilote (13).

4. Procédé selon l'une quelconque des revendications précédentes, **caractérisé en ce que** les registres (14, 15, 20) sont adressés via une instance de contrôle.

5. Procédé selon l'une quelconque des revendications précédentes, **caractérisé en ce que** des informations sont connues, faisant savoir que la première broche d'interface (5) doit être connectée à la seconde broche d'interface (8), dans lequel un avertissement est émis si le premier signal (17) n'est pas reçu à la seconde broche d'interface (8) .

6. Procédé selon l'une quelconque des revendications précédentes, **caractérisé en ce que** de premières informations au sujet d'un premier programme FPGA (30) sont connues, dans lequel les premières informations déterminent pour quelles broches d'interface (3, 4, 5, 6) du premier FPGA (1) des signaux d'activation (16), un registre d'émission (15) et/ou un registre de réception (14) sont respectivement mis en œuvre.

7. Procédé selon la revendication 6, **caractérisé en ce que** le premier programme FPGA (30) est mis en œuvre conjointement avec le premier registre d'émission (15) sur le premier FPGA (1), dans lequel un premier multiplexeur d'émission (40) est mis en œuvre sur le premier FPGA (1), dans lequel le premier multiplexeur d'émission (40) connecte le premier pilote (13) avec le premier registre d'émission (15) et le premier programme FPGA (30), dans lequel le premier multiplexeur d'émission (40) est utilisé pour contrôler si le premier registre d'émission (15) ou le premier programme FPGA (30) définit le signal (17) devant être émis par le premier pilote (13).

8. Procédé selon l'une quelconque des revendications précédentes, **caractérisé en ce que** de secondes informations au sujet d'un second programme FPGA (30) sont connues, dans lequel les secondes informations déterminent pour quelles broches d'interface (7, 8, 9, 10) du second FPGA (2) des signaux d'activation (16), des registres d'émission (15) et/ou des registres de réception (14) sont mis en œuvre.

9. Procédé selon la revendication 8, **caractérisé en ce que** le second programme FPGA (30) est mis en œuvre conjointement avec un second registre d'émission (15) sur le second FPGA (2), dans lequel un second multiplexeur d'émission (40) est mis en œuvre sur le second FPGA (2), dans lequel le second multiplexeur d'émission (40) connecte un second pilote (13) avec le second registre d'émission (15) et le second programme FPGA (30), dans lequel le second multiplexeur d'émission (40) est utilisé pour contrôler si le second registre d'émission (15) ou le second programme FPGA (30) définit le signal (17) devant être émis par le second pilote (13).

10. Procédé selon l'une quelconque des revendications précédentes, **caractérisé en ce qu'**un second registre de réception (14) est mis en œuvre sur une troisième broche d'interface (50), dans lequel le second registre de réception (14) est utilisé pour lire si le premier signal (17) est reçu à la troisième broche d'interface (50), dans lequel la troisième broche d'interface (50) est affectée à la première broche d'interface (5) si le premier signal (17) est reçu à la troisième broche d'interface (50).

11. Procédé selon l'une quelconque des revendications précédentes, **caractérisé en ce qu'**un second signal d'activation (16) est mis en œuvre à la seconde broche d'interface (8), dans lequel un avertissement est émis si le premier signal (17) est reçu à la seconde broche d'interface (8).

12. Procédé selon l'une quelconque des revendications 1 à 5, **caractérisé en ce qu'**un signal d'activation (16), un registre d'émission (15) et un registre de réception (14) sont mis en œuvre respectivement sur toutes les broches d'interface (3, 4, 5, 6, 7, 8, 9, 10, 50, 51, 52).

13. Procédé selon la revendication 12, **caractérisé en ce qu'**une topologie de câblage complète est déterminée.

14. Procédé selon l'une quelconque des revendications précédentes, **caractérisé en ce qu'**un registre d'activation (20) est mis en œuvre pour chaque signal d'activation (16).
